# EUROPEAN PATENT APPLICATION

(11) **EP 2 763 166 A1**
(43) Date of publication of application: **06.08.2014**
(21) Application number: 12836204.3
(22) Date of filing: 20.09.2012
(51) Int. Cl.: H01L 23/36, C23C 24/04, H01L 23/427, H01L 25/07, H01L 25/18, H05K 1/02, H05K 7/20

(54) **HEAT DISSIPATION STRUCTURE, POWER MODULE, METHOD FOR MANUFACTURING HEAT DISSIPATION STRUCTURE AND METHOD FOR MANUFACTURING POWER MODULE**

(30) Priority: 28.09.2011 JP 2011213303
(71) Applicant: NHK Spring Co., Ltd., Yokohama-shi, Kanagawa 236-0004 (JP)
(72) Inventor: YAMAUCHI, Yuichiro, Yokohama-shi, Kanagawa 236-0004 (JP); SAITO, Shinji, Yokohama-shi, Kanagawa 236-0004 (JP); AKABAYASHI, Masaru, Yokohama-shi, Kanagawa 236-0004 (JP); MORI, Shogo, Yokohama-shi, Kanagawa 236-0004 (JP)
(74) Representative: HOFFMANN EITLE
(86) International application number: PCT/JP2012/074102
(87) International publication number: WO 2013/047329

(57) **Abstract**

A heat dissipation structure having high joining strength during a cooling/heating cycle and a high cooling efficiency, a power module, a method of manufacturing the heat dissipation structure, and a method of manufacturing the power module is provided. A power module 1 of the present invention includes: a ceramic substrate 10 having an insulation quality; a metal member 50 containing a metal or an alloy and joined by a brazing material on a surface of the ceramic substrate 10; and a heat dissipation member 40 formed by accelerating a powder containing a metal or an alloy with a gas, and by spraying and depositing the powder in a solid phase state on a surface of the metal member 50, wherein a heat pipe 60 is embedded in the heat dissipation member 40.

## Description

### Field

The present invention relates to a heat dissipation structure including an insulating substrate on which a metal is layered, a power module, a method of manufacturing the heat dissipation structure and a method of manufacturing the power module.

### Background

Conventionally, power modules have been known as a key device for energy-saving that are used in a wide range of fields from industrial and automotive power control to motor control. The power module is an apparatus having an insulating substrate which is a base material (for example, a ceramic substrate). On one of surfaces of the insulating substrate, a chip (transistor) is disposed by soldering on a circuit pattern including a brazed metal plate, and on the other surface thereof, a heat dissipating plate is disposed by soldering through the brazed metal plate (see, for example, Patent Literature 1). As the heat dissipating plate, for example, a metal or an alloy member having high thermal conductivity is used. In this power module, cooling can be performed by transferring heat generated by the chip to the heat dissipating plate through the metal plate and dissipating the heat to the outside.

Furthermore, as a technique of cooling a circuit substrate, on which a part having a large heating value such as a semiconductor element is mounted, there are disclosed a heat pipe type cooling apparatus for the circuit substrate in which a heat pipe is connected to a surface of the circuit substrate on which a circuit pattern is formed, and a method of manufacturing a circuit substrate in which a heat pipe is embedded (see, for example, Patent Literatures 2 or 3).

### Citation List

### Patent Literature

Patent Literature 1: Japanese patent No. 4270140
Patent Literature 2: Japanese Patent Application Laid-open No. 6-181396
Patent Literature 3: Japanese Patent Application Laid-open No. 3-255690

### Summary

### Technical Problem

It is possible to improve durability of joining strength and the like during a cooling/heating cycle of a semiconductor module according to Patent Literature 1 by joining a ceramic substrate containing a silicon nitride of a predetermined plate thickness and a metal plate containing copper or a copper alloy of a predetermined plate thickness by brazing, and by further joining a heat dissipating plate (chip) containing copper or a copper alloy to the ceramic substrate through the metal plate by soldering. In the semiconductor module, however, in order to suppress an influence of distortion due to a difference in coefficients of thermal expansion when joined, it is necessary to use the same metal (copper) or alloy (copper alloy) as a material that constitutes the metal plate and the heat dissipating plate.

Furthermore, according to Patent Literature 2 or 3, although it is possible to increase a cooling efficiency by using a heat pipe, in a case where the heat pipe is joined onto the substrate by soldering, there is a risk that the heat pipe may be damaged by heat. In a case where the heat pipe is embedded into the substrate, the thickness of the substrate is increased, which may be a problem in mounting a chip and the like.

The present invention has been made in view of the abovementioned issues, and an object of the present invention is to provide a heat dissipation structure, a power module, a method of manufacturing the heat dissipation structure, and a method of manufacturing the power module, in which the heat dissipation structure has high joining strength during a cooling/heating cycle, does not damage the heat pipe due to the heat, and can be joined with the heat pipe even in a case where a different material is used for each of the metal plate and the heat dissipating plate.

### Solution to Problem

To solve the problem described above and achieve the object, a heat dissipation structure includes: a ceramic substrate having an insulation quality; a metal member containing a metal or an alloy and joined to a surface of the ceramic substrate by a brazing material; a metal film layer formed by accelerating a powder containing a metal or an alloy with a gas and by spraying and depositing the powder in a solid phase state on a surface of the metal member; and a heat pipe that is in a rod shape and capable of controlling a temperature and comprises a heat absorbing unit configured to absorb heat from outside at one end of the heat pipe and a heat dissipating unit configured to dissipate heat to the outside at another end of the heat pipe, wherein the heat absorbing unit is embedded inside the metal film layer.

Moreover, in the heat dissipation structure according to the above-described invention, the ceramic substrate contains nitride-based ceramic.

Moreover, in the heat dissipation structure according to the above-described invention, the brazing material is an aluminum-based brazing material.

Moreover, in the heat dissipation structure according to the above-described invention, he brazing material contains at least one type of metal selected from the group consisting of germanium, magnesium, silicon and copper.

Moreover, in the heat dissipation structure according to the above-described invention, the metal member contains a metal selected from the group consisting of aluminum, silver, nickel, gold and copper, or an alloy containing the metal.

Moreover, in the heat dissipation structure according to the above-described invention, the metal film layer contains a metal selected from the group consisting of copper, aluminum and silver, or an alloy containing the metal.

Moreover, a power module according to the present invention includes: the heat dissipation structure according to any one of the above-described heat dissipation structures; a second metal member containing a metal or an alloy and joined by the brazing material to a surface, opposing the surface on which the metal film layer is formed, of the ceramic substrate; a circuit layer formed on the second metal member; and a power device mounted on the circuit layer.

Moreover, in the power module according to the above-described invention, the circuit layer is formed by accelerating a powder containing a metal or an alloy with a gas and by spraying and depositing the powder in a solid phase state through a mask on a surface of the second metal member.

Moreover, a method of manufacturing a heat dissipation structure according to the present invention includes: metal member joining step for joining a metal member containing a metal or an alloy to a surface of a ceramic substrate having an insulation quality by a brazing material; and film forming step for arranging, on the metal member, a heat pipe that is in a rod shape and capable of controlling a temperature and includes a heat absorbing unit configured to absorb heat from outside at one end of the heat pipe and a heat dissipating unit configured to dissipate heat to the outside at another end of the heat pipe and forming a metal film layer by accelerating a powder containing a metal or an alloy with a gas and by spraying and depositing the powder in a solid phase state on the metal member on which the heat absorbing unit of the heat pipe is arranged.

Moreover, in the method of manufacturing the heat dissipation structure according to the above-described invention, the metal member joining step includes: brazing material arranging step for arranging the brazing material on the surface of the ceramic substrate; metal member arranging step for arranging the metal member on the brazing material; and heat treating step for heat-treating the ceramic substrate on which the brazing material and the metal member are arranged in order.

Moreover, in the method of manufacturing the heat dissipation structure according to the above-described invention, the brazing material arranging step includes any one of applying a brazing material paste to the ceramic substrate, placing brazing material foil on the ceramic substrate, and adhering the brazing material to the ceramic substrate by the vapor deposition method or the sputtering method.

Moreover, in the method of manufacturing the heat dissipation structure according to the above-described invention, the heat treating step is performed in a vacuum or an inert gas atmosphere.

Moreover, in the method of manufacturing the heat dissipation structure according to the above-described invention, the brazing material is an aluminum-based brazing material containing at least one type of metal selected from the group consisting of germanium, magnesium, silicon and copper.

Moreover, in the method of manufacturing the heat dissipation structure according to the above-described invention, the metal member is 1 mm or below in thickness.

Moreover, in the method of manufacturing the heat dissipation structure according to the above-described invention, the film forming step includes: first film forming step for forming the metal film layer on a surface of the metal member by accelerating a powder containing a metal or an alloy with a gas, and by spraying and depositing the powder in a solid phase state on the surface of the metal member; groove portion forming step for forming a groove portion, in which the heat pipe is to be arranged, by cutting the metal film formed at the first film forming step; and second film forming step for forming the metal film layer, after the heat pipe has been arranged in the groove portion, by accelerating the powder containing a metal or an alloy with the gas, and by spraying and depositing the powder in a solid phase state on the surface of the metal member.

Moreover, a method of manufacturing a power module according to the present invention includes: heat dissipation structure manufacturing step for manufacturing a heat dissipation structure by the method according to any one of the above-described methods; a second metal member joining step for joining a metal member containing a metal or an alloy by a brazing material to a surface, opposing the surface on which the metal film layer is formed, of the ceramic substrate; circuit layer forming step for forming, on the metal member joined at the second metal member joining step, a circuit layer by accelerating a powder containing a metal or an alloy with a gas and by spraying and depositing the powder in a solid phase state on the surface of the metal member joined at the second metal member joining step; and power device mounting step for mounting a power device on the circuit layer, wherein the metal member joining step at the heat dissipation structure manufacturing step and the second metal member joining step are simultaneously performed.

### Advantageous Effects of Invention

According to the present invention, a metal member containing a metal or an alloy is joined to a surface of the ceramic substrate by a brazing material, and then, on a surface of the metal member, a metal film layer is formed by the cold spray method in which a powder containing a metal or an alloy is accelerated with a gas and is sprayed and deposited thereon in a solid phase state. Therefore, a plastic deformation is caused respectively in the metal film layer and in an intermediate layer, whereby a firm metallic bond is formed, and the intermediate layer is pressed against the ceramic substrate when the powder collides into the intermediate layer. Accordingly, a laminate having high adhesion strength between the ceramic substrate and the metal film layer can be obtained. Furthermore, in the present invention, a heat absorbing unit of a heat pipe is embedded inside the metal film layer by the cold spray method, whereby joining strength between the heat pipe and a metal film can be maintained without causing damage to the heat pipe, and the heat dissipation efficiency can be improved.

### Brief Description of Drawings

FIG. 1 is a sectional view illustrating a configuration of a power module which is a heat dissipation structure according to an embodiment of the present invention.
FIG. 2 is an enlarged sectional view of a joining portion of a ceramic substrate and a metal member.
FIG. 3 is a flowchart illustrating a method of manufacturing the power module in FIG. 1.
FIG. 4A is a sectional view illustrating a step of manufacturing a heat dissipation member according to an embodiment of the present invention.
FIG. 4B is a sectional view illustrating a step of manufacturing the heat dissipation member according to an embodiment of the present invention.
FIG. 5 is a schematic view illustrating an outline of a cold spray apparatus.
FIG. 6A is a sectional view illustrating a step of manufacturing a heat dissipation member according to a modification of an embodiment of the present invention.
FIG. 6B is a sectional view illustrating a step of manufacturing the heat dissipation member according to a modification of an embodiment of the present invention.
FIG. 6C is a sectional view illustrating a step of manufacturing the heat dissipation member according to a modification of an embodiment of the present invention.
FIG. 6D is a sectional view illustrating a step of manufacturing the heat dissipation member according to a modification of an embodiment of the present invention. Description of Embodiments

Hereinafter, an embodiment for carrying out the present invention is described in detail with reference to the drawings. The present invention is not to be limited by the embodiment below. Note further that in each of the drawings referred to in descriptions below, a shape, a size, and a positional relationship are schematically illustrated only in a degree to allow understanding of the contents of the present invention. That is, the present invention is not to be limited to the shape, the size, and the positional relationship exemplified in each of the drawings.

### (Embodiment)

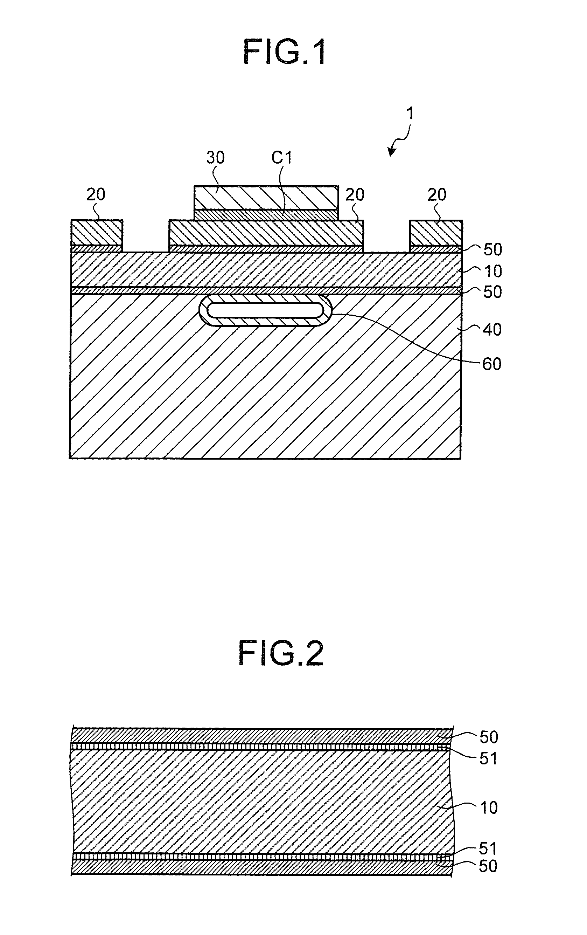

FIG. 1 is a sectional view illustrating a configuration of a power module which is a heat dissipation structure according to an embodiment of the present invention. FIG. 2 is an enlarged sectional view of a joining portion of a ceramic substrate and a metal member. A power module 1 illustrated in FIG. 1 includes: a ceramic substrate 10, which is an insulating substrate; a circuit layer 20 formed on one of surfaces of the ceramic substrate 10 via a metal member 50; a chip 30 joined by a solder C1 on the circuit layer 20; and a heat dissipation member 40 provided on a surface of the ceramic substrate 10 on an opposite side of the circuit layer 20 via a metal member 50.

The ceramic substrate 10 is a substantially plate-shape member made of an insulating material. As the insulating material, for example, nitride-based ceramic such as aluminum nitride and silicon nitride, and oxide-based ceramic such as alumina, magnesia, zirconia, steatite, forsterite, mullite, titania, silica and sialon are used. The nitride-based ceramic are preferred from a viewpoint of durability, heat conductivity and the like.

The circuit layer 20 includes, for example, a metal or an alloy having a good electric conductivity such as aluminum and copper. In the circuit layer 20, a circuit pattern for transmitting an electric signal to the chip 30 and the like is formed.

The chip 30 is realized by a semiconductor element such as a diode, a transistor and an insulated gate bipolar transistor (IGBT). The chip 30 may be a power device usable in a high voltage. A plurality of chips 30 may be provided on the ceramic substrate 10 according to the purpose of use.

The heat dissipation member 40 is a metal film layer formed by the below-described cold spray method. It contains a metal or an alloy having good heat conductivity such as copper, a copper alloy, aluminum, an aluminum alloy, silver and a silver alloy. A heat pipe 60 is embedded inside the heat dissipation member 40.

The heat pipe 60 has a tubular shape forming an internal space which is closed at both ends in a vacuum state, and has a heat absorbing unit for absorbing heat from the outside at one end and a heat dissipating unit for dissipating heat to the outside at the other end. In the internal space of the heat pipe 60, a capillary structure called a wick is formed on a wall surface, and a liquid (for example, water and a small amount of alcohol) is enclosed.

The heat absorbing unit of the heat pipe 60 is embedded in the heat dissipation member 40. In the heat absorbing unit of the heat pipe 60, the liquid enclosed inside is vaporized at a boiling point or below by heat generated by the chip 30 and conducted to the heat dissipation member 40 side through the ceramic substrate 10, whereby the heat dissipation member 40 is cooled by the vaporization heat. The evaporated gas moves to the heat dissipating unit side, returns to the liquid again, and by a capillary phenomenon of the wick, moves to the heat absorbing unit. In the heat pipe 60, by the liquid enclosed inside repeating evaporation and condensation between the heat absorbing unit and the heat dissipating unit, a rapid heat transmission can be performed.

In this embodiment, the heat absorbing unit of the heat pipe 60 is installed inside the heat dissipation member 40 so as to be close to the ceramic substrate 10, whereby it is possible to further improve a heat-absorbing efficiency. A plurality of heat pipes 60 may be embedded inside the heat dissipation member 40 according to a size of the ceramic substrate 10, the number of chips 30 to be mounted, and the like. A plurality of heat dissipation fins may be installed or the like around the heat dissipating unit of the heat pipe 60.

The metal member 50 is joined to the surface of the ceramic substrate 10 by a brazing material 51. The metal member 50 may improve joining strength in joining the ceramic substrate 10 and the circuit layer 20 containing a metal or an alloy and in joining the ceramic substrate 10 and the heat dissipation member 40 containing a metal or an alloy.

The metal member 50 is a foil-shaped rolled member having a thickness of about 0.01 mm to 0.2 mm, for example. In this embodiment, by using this member having a small thickness, damage caused by a difference in a coefficient of thermal expansion between the metal member 50 and the ceramic substrate 10 is prevented in joining with the ceramic substrate 10 and in another step of heat treating. As the metal member 50 arranged on the brazing material 51, it is not limited to a metal member having a foil shape. It is also possible to arrange a plate-shaped metal member as long as it is about 1 mm or below in thickness.

As the metal member 50, a metal or an alloy having a degree of hardness that enables joining with the ceramic substrate 10 by brazing and enables film forming by the cold spray method, described below, is used. This range of hardness may differ by a film forming condition and the like in the cold spray method, whereby it is not possible to determine it unconditionally; however, in general, a metal member having Vickers hardness of 100 HV or below can be applied. Specifically, aluminum, silver, nickel, gold, copper, an alloy containing any of these metals, or the like is listed. From a viewpoint of hardness, workability, and the like, the aluminum or the aluminum alloy is preferred.

The brazing material 51 can be selected according to a type of the ceramic substrate 10 and a type of the metal member 50. Preferably, the brazing material 51 is an aluminum-based brazing material having aluminum as a main component and containing at least one type of metal selected from germanium, magnesium, silicon and copper.

Various known methods are used as a method of disposing the brazing material 51 on the surface of the ceramic substrate 10. For example, it is possible to apply a pasty brazing material containing an organic solvent and an organic binder to the ceramic substrate 10 by the screen printing method. Further, it is possible to place a foil-shaped brazing material (brazing material foil) on the ceramic substrate 10. Still further, the brazing material may be adhered to the surface of the ceramic substrate 10 by the vapor deposition method, the sputtering method, or the like.

Although it may change by the brazing material 51, the metal member 50, and the ceramic substrate 10 to be used, the brazing of the metal member 50 and the ceramic substrate 10 is performed in an inert atmosphere such as a vacuum or a nitrogen gas by heating in a temperature range of 500°C to 630°C, preferably in a temperature range of 550°C to 600°C.

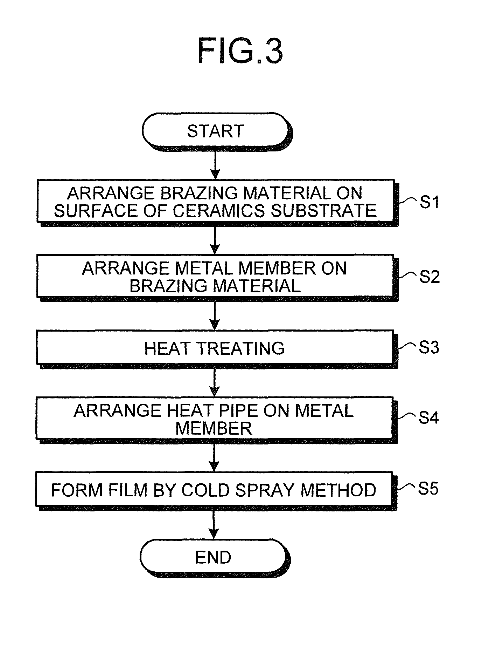

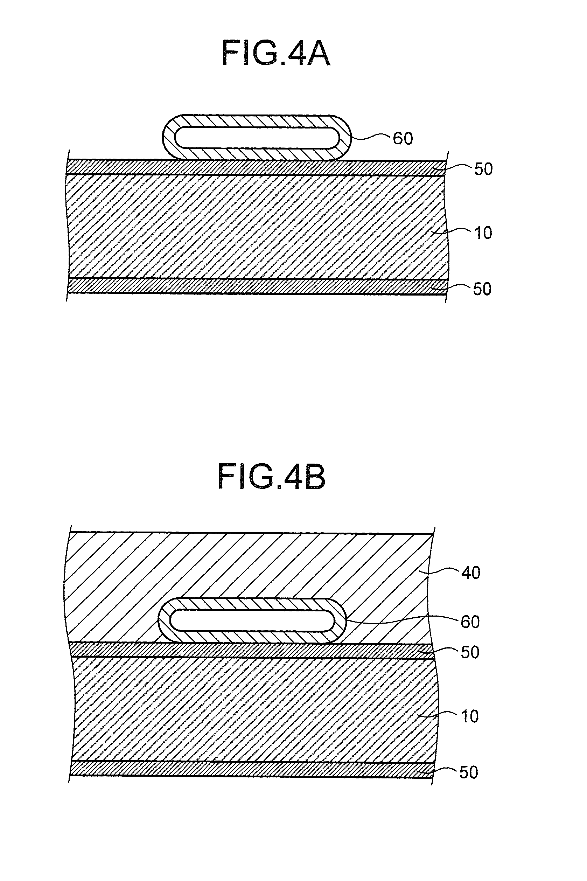

Next, a method of manufacturing the power module 1 is described with reference to FIGS. 3 to 6D. FIG. 3 is a flowchart illustrating the method of manufacturing the power module 1 in FIG. 1. FIGS. 4A and 4B are sectional views illustrating a step of manufacturing the heat dissipation member 40 according to the embodiment of the present invention.

First, on the surface of the ceramic substrate 10, the brazing material 51 is arranged by the screen printing and the like (step S1).

Then, the metal member 50 is arranged on the brazing material 51 (step S2).

The ceramic substrate 10, having the brazing material 51 and the metal member 50 arranged on the surface thereof, is maintained at a predetermined temperature for a predetermined time, and is heat treated in a vacuum (step S3). The brazing material 51 is melted in this heat treating, and a joined body of the ceramic substrate 10 and the metal member 50 can be obtained.

As illustrated in FIG. 2, in a case where the metal members 50 are joined to both surfaces of the ceramic substrate 10, the metal members 50 can be joined to both surfaces of the ceramic substrate 10 by heat treating of the ceramic substrate 10 having the brazing material 51 arranged on both surfaces thereof and being sandwiched by two sheets of the metal members 50. Note that in a case where the metal members 50, each containing a different metal or an alloy, are joined to both surfaces of the ceramic substrate 10 by different brazing materials, joining to the ceramic substrate 10 may be performed from the one using a higher heat treating temperature in order. In FIG. 2, the metal members 50 are joined to both surfaces of the ceramic substrate 10; however, the metal member 50 may be joined by the brazing material 51 at least on a side to form the heat dissipation member 40.

After the metal member 50 has been joined, as illustrated in FIG. 4A, the heat absorbing unit of the heat pipe 60 is arranged on the metal member 50 (step S4).

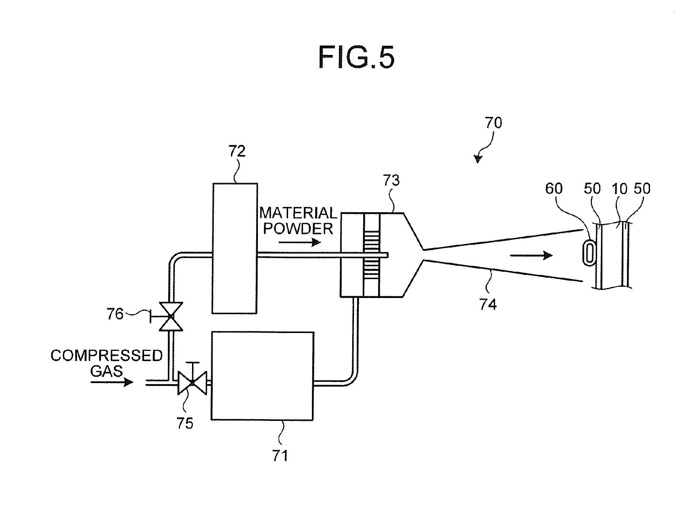

Then, as illustrated in FIG. 4B, a metal film layer is layered on the metal member 50, on which the heat pipe 60 is arranged, by the cold spray method to form the heat dissipation member 40 (step S5). FIG. 5 is a schematic view illustrating an outline of a cold spray apparatus 70 to be used to form the metal film layer.

The cold spray apparatus 70 illustrated in FIG. 5 is provided with: a gas heater 71 for heating a compressed gas; a powder feeding device 72 for housing a material powder of the metal film layer and feeding it to a spray gun 73; a gas nozzle 74 for jetting the heated compressed gas and the material powder fed therein to a base material; and valves 75 and 76 for regulating an amount of supply of compressed gas to each of the gas heater 71 and the powder feeding device 72.

As the compressed gas, helium, nitrogen, an air, and the like may be used. The compressed gas fed to the gas heater 71 is heated to a temperature in a range of 50°C or above, for example, and lower than a melting point of the material powder of the metal film layer, and then is fed to the spray gun 73. Preferably, the heating temperature of the compressed gas is from 300°C to 900°C.

On the other hand, the compressed gas fed to the powder feeding device 72 feeds the material powder in the powder feeding device 72 to the spray gun 73 so as to be in a predetermined discharge amount.

The heated compressed gas is made into a supersonic flow (of about 340 m/s or above) by the gas nozzle 74 having a shape widened toward an end. At this time, preferably, gas pressure of the compressed gas is about 1 to 5 MPa. By controlling the pressure of the compressed gas to be in this level, it is possible to improve the adhesion strength of the metal film layer to the metal member 50. More preferably, it may be processed with pressure of about 2 to 4 MPa. The powder material fed to the spray gun 73 is accelerated by this input of the compressed gas into the supersonic flow, and in the solid phase state, collides into the metal member 50 on the ceramic substrate 10 at a high speed, whereby it is deposited, and a film is formed. The cold spray apparatus 70 is not to be limited to the one illustrated in FIG. 5 as long as it is an apparatus capable of causing the material powder to collide into the ceramic substrate 10 while in the solid phase state to form the film.

In a case where the circuit layer 20 is formed in addition to the heat dissipation member 40 as the metal film layer, film forming may be performed by, for example, arranging a metal mask and the like on which a circuit pattern is formed on an upper layer of the metal member 50, and for example, by using a powder of a metal or an alloy that forms the circuit layer 20 by the cold spray apparatus 70 and the like.

Furthermore, a part such as the chip 30 may be joined to the circuit layer 20 by solder as necessary. Accordingly, the power module 1 illustrated in FIG. 1 is completed.

In this embodiment, the heat dissipation member 40 is formed on the ceramic substrate 10 by the cold spray method. In the cold spray method, a jetting temperature of the metal powder is low, whereby an influence of the thermal stress is mitigated, and it is possible to obtain a metal film, which undergoes no phase transformation and is suppressed from being oxidized. In particular, in a case where materials to be the base material and the film are both metal, plastic deformation occurs between the powder and the base material by a powder to be the film colliding into the base material, whereby an anchoring effect can be obtained. Furthermore, in a region where the plastic deformation occurs, mutual oxidation films are broken when the powder collides into the base material, and a metallic bond is generated between new surfaces, whereby an effect is expected that a laminate having high adhesion strength can be obtained. However, in a case where the metal powder is directly jetted to the ceramic substrate 10 by the cold spray method, the plastic deformation occurs on the metal side only, whereby the sufficient anchoring effect cannot be obtained between the ceramic and the metal. Therefore, there is a problem in that the adhesion strength between the ceramic and the metal film is weak.

The present applicants have found that the adhesion strength can be improved by joining the metal member 50, containing a predetermined metal or a predetermined alloy, to the surface of the ceramic substrate 10 by the brazing material 51, and by forming the heat dissipation member 40 by the cold spray method through metal member 50.

In this embodiment, the metal member 50 is joined to the surface of the ceramic substrate 10 by the brazing material 51, and after the heat pipe 60 is arranged on this metal member 50, the metal film layer is layered by the cold spray method to form the heat dissipation member 40. Therefore, the sufficient anchoring effect is generated when the material powder is collided into the metal member 50 and the heat pipe 60, whereby the metal film layer firmly adhered to the metal member 50 is formed. Furthermore, pressing force in a direction of the ceramic substrate 10 is applied to the intermediate layer 50 and the heat pipe 60 when the material powder is collided, whereby a joining strength of the metal member 50 to the ceramic substrate 10 is improved. As a result, it is possible to obtain the heat dissipation structure in which the ceramic substrate 10, the metal member 50, and the metal film layer are firmly adhered.

Therefore, by applying this heat dissipation structure to the power module 1, it is possible to improve mechanical strength of the whole module.

Furthermore, according to this embodiment, it is possible to dispose the circuit layer 20 and the heat dissipation member 40 without using a machine fastening member, solder, silicone grease, or the like. Therefore, heat conductivity thereof is improved, a structure thereof is simplified, and the size thereof is made smaller than before. Furthermore, in a case where the size of the power module 1 is to be in the same level as before, it is possible to increase a ratio occupied by a major constituent part such as the heat dissipation member 40.

Furthermore, according to this embodiment, the heat pipe 60 is embedded inside the heat dissipation member 40, whereby the heat generated by the circuit layer 20 can be dissipated even more efficiently by the heat pipe 60. Still furthermore, since the heat pipe 60 is joined by the cold spray method, joining with high joining strength is possible while heat damage of the heat pipe 60 can be prevented.

In this embodiment, the metal member 50 is formed on both sides of the ceramic substrate 10; however, it is also possible to form the metal member 50 only on the heat dissipation member 40 side of the ceramic substrate 10.

Furthermore, in this embodiment, the heat pipe 60 is arranged directly on the metal member 50, and the metal film layer is layered by the cold spray method to form the heat dissipation member 40; however, it is also possible to partially laminate the metal film layer on the metal member 50 once, and then to arrange the heat pipe 60.

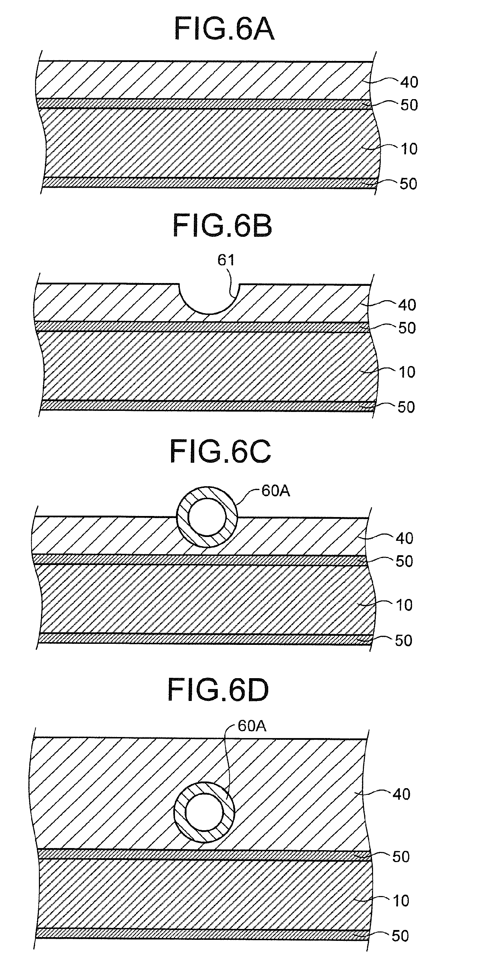

FIGS. 6A to 6D are sectional views illustrating a step of manufacturing a heat dissipation member according to a modification of an embodiment of the present invention.

As illustrated in FIG. 6A, the metal film layer constituting the heat dissipation member 40 is formed on the metal member 50 by the cold spray apparatus 70 and the like illustrated in FIG. 5. On the metal film layer that has been formed, as illustrated in FIG. 6B, a groove portion 61 in which a heat pipe 60A is arranged is formed by cutting and the like.

Then, as illustrated in FIG. 6C, the heat pipe 60A is placed on the groove portion 61. A shape of the groove portion 61 is formed so as to fit a shape of the heat pipe 60A. Therefore, it has an effect that the heat pipe 60A having a round sectional shape as illustrated in FIG. 6C, for example, can be easily arranged at a predetermined position.

After the heat pipe 60A has been arranged, as illustrated in FIG. 6D, the heat dissipation member 40 may be formed by further laminating a metal film layer by the cold spray apparatus 70 and the like.

In the above-described embodiment, as a base material of the laminate, the insulating nitride-based ceramic and the insulating oxide-based ceramic are listed; however, it is also possible to manufacture a laminate on a conductive base material such as carbide-based ceramic and the like by a similar method.

Furthermore, in the above-described embodiment, in a case where an aluminum brazing material is used as the brazing material 51, and aluminum is used as the metal member 50, the metal member 50 and the brazing material 51 are often observed as a substantially uniform layer containing aluminum as the main component. However, by an element distribution analysis, a metal structure observation by SEM, and the like of the metal member 50 and the brazing material 51, the metal member 50 layer derived from a plate-shaped aluminum member and made substantially of aluminum may be distinguishable from the brazing material 51 layer derived from the aluminum brazing material and containing a component other than aluminum (e.g. germanium, magnesium, silicon, copper, and the like) in some cases.

### Industrial Applicability

As described above, a heat dissipation structure, a power module, a method of manufacturing the heat dissipation structure, and a method of manufacturing the power module according to the present invention are useful in fields in which high heat dissipation characteristics and durability are demanded.

### Reference Signs List

- 1: power module
- 10: ceramic substrate
- 20: circuit layer
- 30: chip
- 40: heat dissipation member
- 50: metal member
- 51: brazing material
- 60: heat pipe
- 70: cold spray apparatus
- 71: gas heater
- 72: powder feeding device
- 73: spray gun
- 74: gas nozzle
- 75, 76: valve

## Claims

1. A heat dissipation structure comprising:
a ceramic substrate having an insulation quality;
a metal member containing a metal or an alloy and joined to a surface of the ceramic substrate by a brazing material;
a metal film layer formed by accelerating a powder containing a metal or an alloy with a gas and by spraying and depositing the powder in a solid phase state on a surface of the metal member; and
a heat pipe that is in a rod shape and capable of controlling a temperature and comprises a heat absorbing unit configured to absorb heat from outside at one end of the heat pipe and a heat dissipating unit configured to dissipate heat to the outside at another end of the heat pipe,
wherein the heat absorbing unit is embedded inside the metal film layer.

2. The heat dissipation structure according to claim 1, wherein the ceramic substrate contains nitride-based ceramic.

3. The heat dissipation structure according to claim 1, wherein the brazing material is an aluminum-based brazing material.

4. The heat dissipation structure according to claim 3, wherein the brazing material contains at least one type of metal selected from the group consisting of germanium, magnesium, silicon and copper.

5. The heat dissipation structure according to claim 1, wherein the metal member contains a metal selected from the group consisting of aluminum, silver, nickel, gold and copper, or an alloy containing the metal.

6. The heat dissipation structure according to any one of claims 1 to 5, wherein the metal film layer contains a metal selected from the group consisting of copper, aluminum and silver, or an alloy containing the metal.

7. A power module comprising:
the heat dissipation structure according to any one of claims 1 to 6;
a second metal member containing a metal or an alloy and joined by the brazing material to a surface, opposing the surface on which the metal film layer is formed, of the ceramic substrate;
a circuit layer formed on the second metal member; and
a power device mounted on the circuit layer.

8. The power module according to claim 7 wherein the circuit layer is formed by accelerating a powder containing a metal or an alloy with a gas and by spraying and depositing the powder in a solid phase state through a mask on a surface of the second metal member.

9. A method of manufacturing a heat dissipation structure, the method comprising:
metal member joining step for joining a metal member containing a metal or an alloy to a surface of a ceramic substrate having an insulation quality by a brazing material; and
film forming step for arranging, on the metal member, a heat pipe that is in a rod shape and capable of controlling a temperature and comprises a heat absorbing unit configured to absorb heat from outside at one end of the heat pipe and a heat dissipating unit configured to dissipate heat to the outside at another end of the heat pipe and forming a metal film layer by accelerating a powder containing a metal or an alloy with a gas and by spraying and depositing the powder in a solid phase state on the metal member on which the heat absorbing unit of the heat pipe is arranged.

10. The method of manufacturing the heat dissipation structure according to claim 9, wherein the metal member joining step includes:
brazing material arranging step for arranging the brazing material on the surface of the ceramic substrate;
metal member arranging step for arranging the metal member on the brazing material; and
heat treating step for heat-treating the ceramic substrate on which the brazing material and the metal member are arranged in order.

11. The method of manufacturing the heat dissipation structure according to claim 10, wherein the brazing material arranging step includes any one of applying a brazing material paste to the ceramic substrate, placing brazing material foil on the ceramic substrate, and adhering the brazing material to the ceramic substrate by the vapor deposition method or the sputtering method.

12. The method of manufacturing the heat dissipation structure according to claim 10, wherein the heat treating step is performed in a vacuum or an inert gas atmosphere.

13. The method of manufacturing the heat dissipation structure according to claim 12, wherein the brazing material is an aluminum-based brazing material containing at least one type of metal selected from the group consisting of germanium, magnesium, silicon and copper.

14. The method of manufacturing the heat dissipation structure according to claim 9, wherein the metal member is 1 mm or below in thickness.

15. The method of manufacturing the heat dissipation structure according to any one of claims 9 to 14, wherein the film forming step includes:
first film forming step for forming the metal film layer on a surface of the metal member by accelerating a powder containing a metal or an alloy with a gas, and by spraying and depositing the powder in a solid phase state on the surface of the metal member;
groove portion forming step for forming a groove portion, in which the heat pipe is to be arranged, by cutting the metal film formed at the first film forming step; and
second film forming step for forming the metal film layer, after the heat pipe has been arranged in the groove portion, by accelerating the powder containing a metal or an alloy with the gas, and by spraying and depositing the powder in a solid phase state on the surface of the metal member.

16. A method of manufacturing a power module, the method comprising:
heat dissipation structure manufacturing step for manufacturing a heat dissipation structure by the method according to any one of claims 9 to 14;
a second metal member joining step for joining a metal member containing a metal or an alloy by a brazing material to a surface, opposing the surface on which the metal film layer is formed, of the ceramic substrate;
circuit layer forming step for forming, on the metal member joined at the second metal member joining step, a circuit layer by accelerating a powder containing a metal or an alloy with a gas and by spraying and depositing the powder in a solid phase state on the surface of the metal member joined at the second metal member joining step; and
power device mounting step for mounting a power device on the circuit layer,
wherein the metal member joining step at the heat dissipation structure manufacturing step and the second metal member joining step are simultaneously performed.
